# EUROPEAN PATENT SPECIFICATION

(11) **EP 4 003 632 B1**
(45) Date of publication and mention of the grant of the patent: **13.12.2023**
(21) Application number: 20744036.3
(22) Date of filing: 23.07.2020
(51) Int. Cl.: B23K 20/10, B23K 101/40

(54) **POWER SEMICONDUCTOR MODULE AND METHOD OF FORMING THE SAME**
LEISTUNGSHALBLEITERMODUL UND VERFAHREN ZUR FORMUNG DAVON
MODULE SEMI-CONDUCTEUR DE PUISSANCE ET SON PROCÉDÉ DE FABRICATION

(30) Priority: 25.07.2019 EP 19188325
(43) Date of publication of application: 01.06.2022
(73) Proprietor: Hitachi Energy Ltd, 8050 Zürich (CH)
(72) Inventor: GUILLON, David, 8857 Vorderthal (CH)
(74) Representative: Michalski Hüttermann & Partner Patentanwälte mbB
(86) International application number: PCT/EP2020/070879
(87) International publication number: WO 2021/013967

(56) References cited:
- DE-A1-102014 104 496
- JP-A- 2015 146 393
- US-A1- 2011 058 342

## Description

### Technical Field

The present invention relates to a method of forming a power semiconductor module and in particular to welding a terminal to a substrate in the course of forming power semiconductor module. The present invention further relates to a semi-finished product of a power semiconductor module. The present invention further relates to a power semiconductor module.

### Background Art

Power semiconductor modules are generally widely known in the art. There are different connection techniques in order to connect a terminal to an electrically conductive structure, such as a substrate, or substrate metallization, respectively.

Welding, such as ultrasound welding (USW), also called ultrasonic welding, is a known technique for connecting a terminal to a substrate metallization which may be used for producing a high reliability and high temperature power electronics module. Especially, ultrasound welding is widely used for joining terminals made from copper to a ceramic substrate having a copper metallization.

After having performed the welding step preferably by introducing a welding force into the terminal foot top surface, knurling patterns are introduced into this surface by the force of the welding tool.

As an alternative, it is known to use laser welding to join a terminal to a substrate, or substrate metallization, respectively. However, when thinking about this technique, there is the risk of formation of brittle intermetallic phases when connecting dissimilar materials.

DE 10 2014 104 496 A1 describes an apparatus and a method for connecting a connection element of a power semiconductor module to a conductor track by welding.

The prior art thus still gives room for improvements especially regarding connecting a terminal to a substrate in the course of forming a power semiconductor module in a gentle and reliable manner.

### Summary of invention

It is therefore an object of the invention to provide a solution for overcoming at least one disadvantage of the prior art at least in part. It is especially an object of the present invention to provide a solution for reliably and gently connecting a terminal to a substrate leading to a high quality arrangement for a power semiconductor module.

These objects are solved at least in part by the features of independent claims 1 and 6. Advantageous embodiments are given in the dependent claims, in the further description as well as in the figures, wherein the described embodiments can, alone or in any combination of the respective embodiments, provide a feature of the present invention unless not clearly excluded.

Described is a method of connecting a terminal to a substrate for forming a power semiconductor module by using ultrasound welding, wherein the terminal comprises a first connection area being located at a terminal foot, the terminal further comprises a second connection area, being located opposite to the first connection area at the terminal foot, the substrate comprises a third connection area wherein the method comprises the following steps:
a) Bringing the first connection area in contact to the third connection area;
b) Connecting the terminal to the substrate by acting on the second connection area with an ultrasound welding tool;
c) Smoothening the second connection area by performing a smoothening step after having performed step b); and
d) Connecting at least one electrical connection to the second connection area.

Such a method provides significant advantages over solutions of the prior art, especially with regard to reliably and securely connecting a terminal to a substrate, or substrate metallization, respectively, wherein this leads to a high quality arrangement.

The present invention thus refers to a method of connecting a terminal to a substrate for forming a power semiconductor module. Thus, the method is suited and intended for being performed in the course of producing a power semiconductor module and in detail deals with connecting a terminal to a substrate and thus particularly to a substrate metallization.

Connecting in the sense of the present invention shall thereby mean mechanically and electrically connecting the terminal to the substrate, or substrate metallization, respectively.

With this regard, generally, the power semiconductor module may have functionalities as known in the art. For example, the power semiconductor module which should be produced comprises a metallization such as provided on a ceramic substrate, which metallization is adapted for electrically connecting a terminal which should be connected to this metallization with respective power semiconductor devices.

Located on the substrate metallization are also power semiconductor devices which are also called chips. Such power semiconductor devices may be generally formed as it is known in the art and may comprise, inter alia, transistors, or switches, respectively, such as MOSFETs and/or IGBTs and/or the plurality of power semiconductor devices may comprise diodes. The power semiconductor devices may be respectively interconnected and may thus be in electrical contact, such as in galvanic contact with the metallization.

The substrate may generally be formed from a main layer being a ceramic main layer, and from a top and bottom metallization. For example, it may be provided that the substrate is an Al/AlN/Al substrate, thus having a AlN man layer and aluminium top and bottom metallization. This allows a high cycling reliability and no silver ion migration issue appears. However, a copper metallization as top and/or bottom metallization may also be preferred.

With regard to the terminal and the metallization which should be connected to each other, it is provided that the terminal has a first connection area and that the substrate, or substrate metallization, respectively, has a third connection area.

Therefore, the first connection area is that area of the terminal which is intended to be connected to the substrate metallization and correspondingly, the third connection area is that area of the substrate, or substrate metallization, respectively, which is intended to be connected to the terminal.

In fact, it is also known that advanced designs of power semiconductor modules require welding of the terminal to the substrate and thus particularly the first connection area to the third connection area. As an example, it is known to connect a copper based terminal to an aluminum metallization of a ceramic substrate. Further, it may be required to connect a hard copper terminal, such as CuNiSi press pin auxiliary terminal, on a ceramic substrate having a copper metallization. However, independently from the used material combination, ultrasound welding is a preferred option for connecting the terminal to the substrate. This may be due to the fact that such techniques are known for connecting a terminal to a substrate for forming a reliable and high temperature power electronics module. Especially, ultrasound welding is widely used for joining e.g. terminals made from copper to a ceramic substrate having copper metallization.

Further, it is provided that the terminal has a second connection area, the second connection area being located opposite to the first connection area at the terminal foot.

With regard to the method of connecting the terminal to the substrate, or substrate metallization, respectively, it is further provided that this method comprises the following steps.

Firstly and according to method step a), the method comprises the step of bringing the first connection area in contact to the third connection area. According to this step, the terminal is thus positioned at its final position at which it should be connected to the substrate metallization, for example. This step may be realized for example in a manual manner or in an automated manner, such as by means of an automated positioning device.

Further and according to method step b), the present method comprises the step of connecting the terminal to the substrate by acting on the second connection area with a welding tool.

This step may generally be performed as it is known in the art by using conventional ultrasound welding e.g. by using a sonotrode and/or by introducing the welding energy into the terminal foot.

In detail, when the terminal is located at is final position, i.e. at the position at which it should be connected to the substrate, and thus after having performed step a), a welding tool is provided. The welding tool, such as a sonotrode, is located and operated such, that the welding energy is introduced into the terminal foot at the second connection area. The second connection area mostly is the upper side of the terminal foot.

The welding parameters as used may be chosen in an adequate manner and may correspond to these parameters which are used in the prior art. Generally, the welding parameters may be dependent from the material of the terminal, the material of the substrate, or substrate metallization respectively, and thus in dependence of the material of the first, second and third connection areas. Further, the thickness of the terminal foot may have an influence on the welding parameters and thus the distance between the first and third connection areas.

However, using ultrasound welding as connection technique may lead to disadvantages especially in case the second connection area should be used for connecting a further electrical connection thereto, such as a wire bond connection. With this regard, it was found that especially by using ultrasound welding, the surface which was used for introducing the welding energy by the welding tool is comparably rough. In more detail, it may arise that the second connection area and thus in particular the terminal foot top surface will be deformed by the knurling pattern of the welding tool such as of a sonotrode.

In such situations, it was found that the second connection area after having performed the welding step is deformed such that a kind of knurling pattern is introduced into this surface of the terminal, or terminal foot, respectively.

Further and according to the method as described here, it is provided, according to method step c), that the method comprises the further step of smoothening the third connection area by performing a smoothening step.

Smoothening of the surface may be done directly after having performed the welding step or it may be performed as a completely different and isolated process step. Further, smoothening may be realized by using one step or a plurality of especially subsequent steps. It is thus provided that after step c), the second connection area is smoother compared to the second connection area before step c).

Especially this step may provide significant advantages over the prior art in which terminals are connected to a substrate by means of ultrasound welding.

In particular, by smoothening the surface of the terminal foot and thus the second connection are, the respective rough surface such as the knurling structure, may be removed. Instead, the surface becomes smooth. It has now be found that by smoothening the second connection area and thus in most cases the upper surface of the terminal foot, properties may arise which are superb for providing a further step of connecting an electrical connection to the second connection area and thus particularly to the upside surface of the terminal foot.

Therefore, this step allows that the second connection area is designed for fixing an electrical connection, such as a wire bond thereto. This allows connecting further parts of an electrical circuit of the power semiconductor module to the terminal. For example, it may be provided to fix a wire bond to the second connection area which connects the terminal to a power semiconductor device of the electric circuit.

This step especially takes advantage of the fact that after having smoothened the terminal foot, or the second connection area, respectively, the electrical connection may reliably be connected to the second connection area. In fact, a long-term stability of the electrical connection may be reached and further the efficiency of the power semiconductor module may be improved.

With this regard, the above-named advantages are especially effective in case step d) comprises welding a wire bond to the second connection area. The wire bonds may be formed from a material selected from the group consisting of copper, aluminium and an alloy comprising at least one of the before-named metals, for example.

Further, the wire bond or the other electrical connection which is fixed to the second connection area may connect the terminal foot with a power semiconductor device.

With regard to the smoothening step, a smoothening generally is realized in case the smoothness is increased and thus is higher after step c) compared to the state before step c).

It may be preferred that step c) is performed by and thus comprises a material removing step. According to this embodiment, it may thus be provided that the knurling structure, for example, which was formed on the second connection area may be removed by removing material. This step allows providing an especially smooth surface so that the advantages as described above may be realized especially effectively. Further, this embodiment may be realized in an especially reliable manner in case the terminal foot has a suitable thickness.

According to the above, this method step may be performed for examples in case the terminal, or terminal foot, respectively, is formed from a material which has a comparably high hardness. Thus, for example, this embodiment may be realized in combination with a terminal which is formed from a copper alloy, such as from CuNiSi, at least at the terminal foot, or second connection area, respectively, wherein these examples, however, are in no way limiting.

Generally, the specific steps for performing this method may be chosen according to the specific needs. As non-limiting examples, it may be provided that the material removing step comprises at least one process selected from the group consisting of grinding, polishing, flattening, shearing. It was found that especially these examples may provide a very smooth surface and may well be applicable at the materials of the terminal foot like described above, for example. Further, these methods provide a surface which may well be used for connecting wire bonds, for example, such as by welding.

It may further be provided that step c) comprises applying at least one of pressure and heat to the second connection area. Thus, this embodiment includes a pressure based smoothening step and/ or a heat based smoothening step. This embodiment as well may lead to a very smooth surface. It may particularly be realized in combination with a comparable soft material and/or in combination with a material having a low melting point. Thus, for example, this embodiment may be realized in combination with a terminal which is formed from copper, such as soft annealed copper, at least at the terminal foot, or second connection area, respectively.

This step may for example be used by using a pressure exerting tool which acts on the second connection area or with a heat exerting tool which acts on the connection area or with both or a combination thereof.

It may further be provided that the terminal is formed at least at its terminal foot, and thus at the second connection area, from a material selected from the group consisting of copper, such as soft annealed copper or a copper alloy, such as CuNiSi.

These materials combine excellent electronic properties with good workability. Thus, terminals being formed from these materials show excellent working conditions allowing the power semiconductor module to work very efficiently. Apart from this, it may be allowed that the second connection area is provided with a very smooth surface, such as by using the methods as described above. The present method thus avoids the generally appearing effects of ultrasound welding according to which the structure of the terminal foot and especially of the second connection area has deteriorated properties in case a further welding step takes place in order to connect a wire bond, for example, at the second connection area. In other words, the top foot surface, for example, after having performed the ultrasound welding is not or only hardly arranged for providing a further bonding step of bonding an electrical connection thereto.

In contrast to this generally appearing effect, the present invention allows that the surfaces which come into contact with a welding tool when connecting the terminal to the electrically conductive structures by means of ultrasound welding or by means of laser welding, have a structure which is well suited for allowing electrically contacting a further electrical contact to this area. This may be realized in order to connect the terminal with further components of the electric circuit, such as particularly with power semiconductor devices.

It may thus be allowed that a very high quality bond between the terminal and the electrical connection, such as a wire bond, may be reached.

Therefore a very reliable connection of the respective surfaces may be reached which in turn may allow a high working capability of the power semiconductor module which might avoid damages due to low quality bondings.

Apart from that, the power semiconductor module may work with high safety due to the stable and reliable connection between the terminal and the substrate, or substrate metallization, respectively.

The above advantages further allow that the design and the package of a power semiconductor module to be produced is significantly improved in that the terminal as such may be used for a connection to the power semiconductor devices. As a result, the substrate surface such as the surface of the metallization may be optimized by achieving a greater design freedom in that an electrical connection which according to the prior art was connected to the metallization can now be connected to the terminal on the smoothened surface. As a result, the area gained on the metallization can be used for placing more power semiconductor devices thereon, allowing the power semiconductor module to work with an especially good performance and efficiency.

The present invention thus provides a solution for the challenge in the course of producing power semiconductor modules according to which the design of a power module package with a given footprint is the tradeoff between the area of the substrate metallization required for the power semiconductor devices versus the areas of the substrate metallization required for further components such as wire bonds, terminals, space for process margins and so on.

It can thus be seen that the method as described here provides significant advantages over solutions of the prior art for forming a power semiconductor module.

The present invention thus also relates to a method of forming a power semiconductor module which comprises the method of connecting a terminal to a substrate wherein it is referred to the method of connecting a terminal to a substrate with regard to the respective features and advantages.

This method of forming a power semiconductor module may thus further comprise the steps of providing power semiconductor devices, internal and/or external electrical connections and protection means, such as one or more mold bodies and/or housings etc. like it is generally known in the prior art.

With regard to further advantages and technical features of the method it is referred to the semi-finished product, the power semiconductor module, the method of forming a power semiconductor module, the figures and the further description.

Further described is a semi-finished product of a power semiconductor module, formed from and thus particularly comprising a terminal and a substrate, wherein the terminal comprises a first connection area being located at a terminal foot, the terminal further comprises a second connection area, being located opposite to the first connection area at the terminal foot, the substrate comprises a third connection area and the first connection area is connected to the third connection area, wherein the second connection area has a smoothened surface, having a surface roughness Ra in the range of < 400 µm and an electrical connection is connected to the second connection area.

Such a semi-finished product allows significant advantages over the solutions of the prior art especially in the course of forming a power semiconductor module.

With this regard, especially the feature according to which the second connection area has a smoothened surface may provide significant advantages over the prior art in which terminals are connected to a substrate by means of ultrasound welding.

In particular, by smoothening the surface of the terminal foot and thus the second connection area, the respective rough surface such as the knurling structure which appears in course of ultrasound welding may be removed. Instead, the surface becomes smooth and thus has properties being superb for a subsequent welding step and thus for connecting a further electrical connection to the second connection area.

With regard to a smoothened surface, it may be preferred that the surface of the second connection area has a surface roughness Ra in the range of ≤ 400 µm, particularly ≤ 300µm, such as ≤ 200µm. The surface roughness Ra may be understood as the arithmetic average value of particularly filtered roughness profile determined from deviations about the center line within the evaluation length and may be determined by scanning electron microscopy.

With regard to the terminal, it may be provided that it may comprise one or more of collector terminals, emitter terminals and auxiliary terminals.

Therefore, this step allows that the surface which was in contact with a welding tool, when connecting the terminal to the electrically conductive structures by means of ultrasound welding, has a structure which is well suited for allowing electrically contacting a further electrical contact to this area afterwards. This may be realized in order to connect the terminal with further components of the electric circuit, such as particularly with power semiconductor devices.

It may thus be allowed that a very high quality bond between the terminal and the electrical connection, such as a wire bond, may be reached.

Therefore a very reliable connection of the respective surfaces may be reached which in turn may allow a high working capability of the power semiconductor module which might avoid damages due to low quality bondings.

Apart from that, the power semiconductor module may work with high safety due to the stable and reliable connection between the terminal and the substrate, or substrate metallization, respectively.

Furthermore, the semi-finished product may allow a power semiconductor module to be produced which may work with an especially high performance and efficiency.

It is provided that an electrical connection is connected to the second connection area. For example, it may be provided that a wire bond or a plurality of wire bonds is connected to the second connection area.

With regard to further advantages and technical features of the semi-finished product it is referred to the methods, the power semiconductor module, the figures and the further description.

Further described is a power semiconductor module, wherein the power semiconductor module comprises a semi-finished product like described in the further description. It is further provided that the power semiconductor module comprises a semi-finished product as described before and may further have features as generally known in the art for power semiconductor modules, such as power semiconductor devices and so on. For example, the power semiconductor module may comprise an IGBT.

Such a power semiconductor module may provide significant advantages over the prior art. In particular, the advantages are especially effective in case an electrical connection is connected to the second connection are. In particular, it may be provided that wire bonds are welded to the second connection area.

To summarize, the connection of the electrical connector, such as of the wire bonds, to the second connection surface, may be formed by realizing a high quality connection and may thus lead to a high working stability of the module and a superb long-term stability. Further, the power semiconductor module may work with an especially high effectivity. With regard to further advantages and technical features of power semiconductor module it is referred to the semi-finished product, the methods, the figures and the further description.

### Brief description of drawings

These and other aspects of the invention will be apparent from and elucidated with reference to the embodiments described hereinafter. Individual features disclosed in the embodiments can constitute alone or in combination an aspect of the present invention. Features of the different embodiments can be carried over from one embodiment to another embodiment.

In the drawings:
Fig. 1 shows a sectional side view of a power semiconductor module according to the invention;
Fig. 2 shows a sectional side view of a welding step for connecting a terminal to a substrate by means of a welding tool; and
Fig. 3 shows a sectional side view of a semi-finished product for forming a power semiconductor module after a smoothening step for smoothening the terminal.

### Description of embodiments

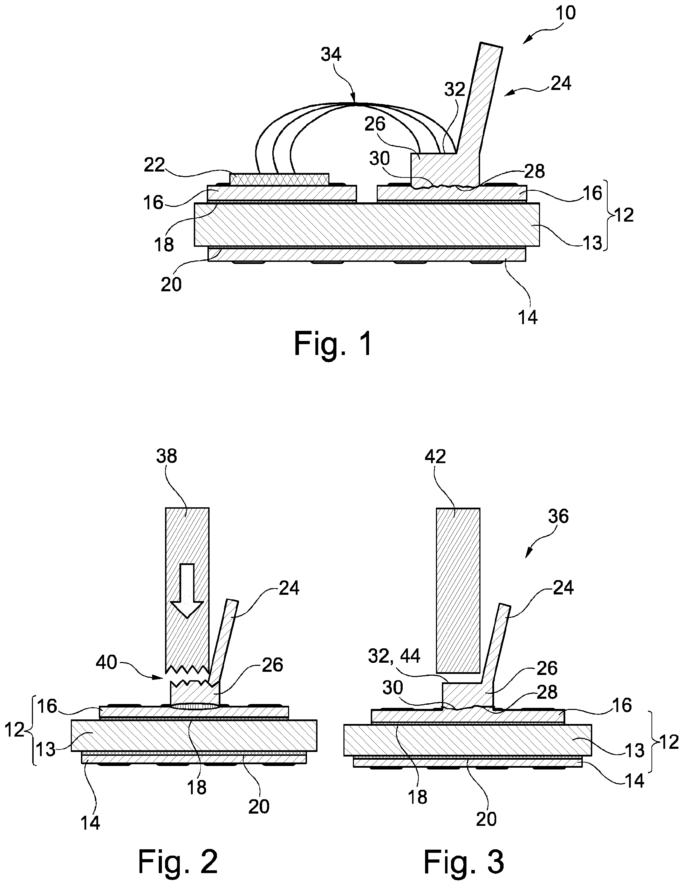

Fig. 1 shows a power semiconductor module 10. The power semiconductor module 10 comprises a substrate 12 which is provided with a bottom metallization 14 and with a top metallization 16. The bottom metallization 14 may be connected to the substrate 12, or its main layer 13, respectively, by a solder layer 20 and may on the opposite side be connected to a baseplate not shown in these figures. Further, the top metallization 16 may be connected to the substrate main layer 13 by a further solder layer 18.

It is further shown that on a left part of the top metallization 16, a power semiconductor device 22 is provided. The power semiconductor device 22, or a plurality of power semiconductor devices 22 as provided, may generally be formed as it is known in the art and may comprise, inter alia, transistors, or switches, respectively, such as MOSFETs and/or IGBTs and/or the plurality of power semiconductor devices 22 may comprise diodes.

Apart from the power semiconductor device 22, it is shown that on a right part of the top metallization 16, a terminal 24 is provided. The terminal 24 may e.g. be an emitter terminal, a collector terminal or an auxiliary terminal.

It is further shown that the terminal 24 comprises a terminal foot 26 which is connected to the substrate 12, or its substrate top metallization 16, respectively. With this regard, it is shown that the terminal 24 comprises a first connection area 28 being located at the terminal foot 26, wherein the first connection area 28 is connected to the substrate 12, or its substrate top metallization 16, respectively. The substrate 12 has a third connection area 30 at the top metallization 16. The third connection area 30 is in turn connected to the first connection area 28 of the terminal 14.

With regard to the terminal 24, it is further provided that the terminal foot 26 has a second connection area 32, the second connection area 32 being located opposite to the first connection area 28 at the terminal foot 26. Located at the second connection area 32 are further electrical connections. In more detail, it is shown that wire bonds 34 are fixed to, in particular welded to, the second connection area 32.

The wire bonds 34 provide an electrical connection from the terminal 24 to the power semiconductor device 22.

It can further be seen that the second connection area 32 has a smoothened surface. This feature allows for a durable and effective connection of the electrical connection, or the wire bonds, 34 to the second connection area 32.

This feature is described in more detail in figures 2 and 3. With this regard, figures 2 and 3 show a method of connecting the terminal 24 to a substrate 12. This method particularly leads to a semi-finished product 36 of a power semiconductor module 10 and may thus be used in the course of forming a power semiconductor module 10.

With this regard, figure 2 shows a state of the terminal 24 after having performed a step of ultrasound welding for connecting the terminal 24 to the substrate 12. It can be seen that due to the knurling structure of a welding tool 38, the second connection area 32 of the terminal foot 26 also has a knurling structure 40.

In this state, however, it is not or not in a suitable manner possible to connect further electrical connections to the second connection area 32. Therefore, the present invention proposes to smoothen the second connection area 32 after the welding step.

This is more closely shown in figure 3. According to figure 3, it is shown that the second connection area 32 is smoothened which provides a second connection area 32 having a very smooth surface. Smoothening of the second connection area 32 may for example be realized by using a smoothening tool 42 having a flat surface 44 which acts on the second connection area 32 with heat and/or pressure, preferably with both, heat and pressure, like shown in figure 3. Alternatively or additionally, it may be provided that smoothening of the second connection area 32 may be realized by means of a material removing step, such as grinding. Therefore, in the state as shown in figure 3, it is well possible to connect electrical connections, such as the wire bonds 34 as shown in figure 1 to the second connection area 32. This allows a durable and long-term stable connection of the wire bonds 34 and further a high and effective performance of the power semiconductor module 10.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 10: power semiconductor module
- 12: substrate
- 13: main layer
- 14: metallization
- 16: metallization
- 18: solder layer
- 20: solder layer
- 22: power semiconductor device
- 24: terminal
- 26: terminal foot
- 28: first connection area
- 30: third connection area
- 32: second connection area
- 34: wire bond
- 36: semi-finished product
- 38: welding tool
- 40: structure
- 42: smoothening tool
- 44: surface

## Claims

1. A method of connecting a terminal (24) to a substrate (12) for forming a power semiconductor module (10) by using ultrasound welding, wherein
the terminal (24) comprises a first connection area (28) being located at a terminal foot (26),
the terminal (24) further comprises a second connection area (32) being located opposite to the first connection area (28) at the terminal foot (26),
the substrate (12) comprises a third connection area (30), and
the method comprises the following steps:
a) Bringing the first connection area (28) in contact to the third connection area (30);
b) Connecting the terminal (24) to the substrate (12) by acting on the second connection area (32) with an ultrasound welding tool (38);
c) Smoothening the second connection area (32) by performing a smoothening step after having performed step b); and
d) Connecting at least one electrical connection to the second connection area (32) after having performed step c).

2. The method according to the previous claim, wherein step d) comprises welding a wire bond (34) to the second connection area (32).

3. The method according to any of the previous claims, wherein step c) comprises a material removing step.

4. The method according to the previous claim, wherein the material removing step comprises at least one of grinding, polishing, flattening, shearing.

5. The method according to according to any of the previous claims, wherein step c) comprises applying at least one of pressure and heat to the second connection area (32).

6. A semi-finished product (36) of a power semiconductor module (10), formed from a terminal (24) and a substrate (12), wherein
the terminal (24) comprises a first connection area (28) being located at a terminal foot (26),
the terminal (24) further comprises a second connection area (32) being located opposite to the first connection area (28) at the terminal foot (26),
the substrate (12) comprises a third connection area (30),
the first connection area (28) is connected to the third connection area (30),
the second connection area (32) has a smoothened surface with a surface roughness Ra in the range of < 400 µm and
an electrical connection is connected to the second connection area (32).

7. A power semiconductor module (10) comprising a semi-finished product (36) according to the previous claim.

8. A method of forming a power semiconductor module (10), wherein the method comprises a method according to any of the previous claims 1 to 5.

## Patentansprüche

1. Verfahren zum Verbinden eines Anschlusses (24) mit einem Substrat (12) zum Ausbilden eines Leistungshalbleitermoduls (10) mittels Ultraschallschweißen, wobei
der Anschluss (24) einen ersten Verbindungsbereich (28) umfasst, der sich an einem Anschlussfuß (26) befindet,
der Anschluss (24) ferner einen zweiten Verbindungsbereich (32) umfasst, der sich gegenüber dem ersten Verbindungsbereich (28) an dem Anschlussfuß (26) befindet,
das Substrat (12) einen dritten Verbindungsbereich (30) umfasst und
das Verfahren folgende Schritte umfasst:
a) Inkontaktbringen des ersten Verbindungsbereichs (28) mit dem dritten Verbindungsbereich (30);
b) Verbinden des Anschlusses (24) mit dem Substrat (12) durch Einwirken auf den zweiten Verbindungsbereich (32) mit einem Ultraschallschweißwerkzeug (38);
c) Glätten des zweiten Verbindungsbereichs (32) durch Durchführen eines Glättungsschritts nach dem Durchführen von Schritt b); und
d) Verbinden wenigstens einer elektrischen Verbindung mit dem zweiten Verbindungsbereich (32) nach dem Durchführen von Schritt c).

2. Verfahren nach dem vorangehenden Anspruch, wobei Schritt d) das Schweißen einer Drahtbondverbindung (34) an den zweiten Verbindungsbereich (32) umfasst.

3. Verfahren nach einem der vorangehenden Ansprüche, wobei Schritt c) einen Materialabtragungsschritt umfasst.

4. Verfahren nach dem vorangehenden Anspruch, wobei der Materialabtragungsschritt wenigstens eines aus Schleifen, Polieren, Ebnen, Scheren umfasst.

5. Verfahren nach einem der vorangehenden Ansprüche, wobei Schritt c) ein Beaufschlagen des zweiten Verbindungsbereichs (32) mit wenigstens einem aus Druck und Wärme umfasst.

6. Halbfertigprodukt (36) eines Leistungshalbleitermoduls (10), das aus einem Anschluss (24) und einem Substrat (12) ausgebildet ist, wobei
der Anschluss (24) einen ersten Verbindungsbereich (28) umfasst, der sich an einem Anschlussfuß (26) befindet,
der Anschluss (24) ferner einen zweiten Verbindungsbereich (32) umfasst, der sich gegenüber dem ersten Verbindungsbereich (28) an dem Anschlussfuß (26) befindet,
das Substrat (12) einen dritten Verbindungsbereich (30) umfasst,
der erste Verbindungsbereich (28) mit dem dritten Verbindungsbereich (30) verbunden ist,
der zweite Verbindungsbereich (32) eine geglättete Oberfläche mit einer Oberflächenrauheit Ra im Bereich von < 400 µm aufweist und
eine elektrische Verbindung mit dem zweiten Verbindungsbereich (32) verbunden ist.

7. Leistungshalbleitermodul (10), das ein Halbfertigprodukt (36) nach dem vorangehenden Anspruch umfasst.

8. Verfahren zur Ausbildung eines Leistungshalbleitermoduls (10), wobei das Verfahren ein Verfahren nach einem der vorangehenden Ansprüche 1 bis 5 umfasst.

## Revendications

1. Procédé de connexion d'une borne (24) à un substrat (12) pour former un module semi-conducteur de puissance (10) par soudage par ultrasons, dans lequel
la borne (24) comprend une première zone de connexion (28) située au niveau d'un pied de borne (26),
la borne (24) comprend en outre une deuxième zone de connexion (32) située à l'opposé de la première zone de connexion (28) au niveau du pied de borne (26),
le substrat (12) comprend une troisième zone de connexion (30), et
le procédé comprend les étapes suivantes :
a) mise en contact de la première zone de connexion (28) avec la troisième zone de connexion (30) ;
b) connexion de la borne (24) au substrat (12) par une action sur la deuxième zone de connexion (32) avec un outil de soudage par ultrasons (38) ;
c) lissage de la deuxième zone de connexion (32) par réalisation d'une étape de lissage après avoir effectué l'étape b) ; et
d) connexion d'au moins une connexion électrique à la deuxième zone de connexion (32) après avoir effectué l'étape c).

2. Procédé selon la revendication précédente, dans lequel l'étape d) comprend le soudage d'un fil de connexion (34) à la deuxième zone de connexion (32).

3. Procédé selon l'une quelconque des revendications précédentes, dans lequel l'étape c) comprend une étape de retrait de matière.

4. Procédé selon la revendication précédente, dans lequel l'étape de retrait de matière comprend au moins une opération parmi un meulage, un polissage, un aplanissement, un cisaillement.

5. Procédé selon l'une quelconque des revendications précédentes, dans lequel l'étape c) comprend l'application de pression et/ou de chaleur à la deuxième zone de connexion (32).

6. Produit semi-fini (36) d'un module semi-conducteur de puissance (10), formé à partir d'une borne (24) et d'un substrat (12), dans lequel
la borne (24) comprend une première zone de connexion (28) située au niveau d'un pied de borne (26),
la borne (24) comprend en outre une deuxième zone de connexion (32) située à l'opposé de la première zone de connexion (28) au niveau du pied de borne (26),
le substrat (12) comprend une troisième zone de connexion (30),
la première zone de connexion (28) est connectée à la troisième zone de connexion (30),
la deuxième zone de connexion (32) a une surface lissée avec une rugosité de surface Ra dans la plage de < 400 µm et
une connexion électrique est connectée à la deuxième zone de connexion (32).

7. Module semi-conducteur de puissance (10) comprenant un produit semi-fini (36) selon la revendication précédente.

8. Procédé de formation d'un module semi-conducteur de puissance (10), le procédé comprenant un procédé selon l'une quelconque des revendications 1 à 5 précédentes.
